# EUROPEAN PATENT SPECIFICATION

(11) **EP 2 697 810 B1**
(45) Date of publication and mention of the grant of the patent: **18.02.2015**
(21) Application number: 12728818.1
(22) Date of filing: 12.04.2012
(51) Int. Cl.: H01G 9/20, H01L 51/00

(54) **SINTERING PROCESS OF METAL OXIDE BASED FORMULATIONS**
VERFAHREN ZUM SINTERN VON FORMULIERUNGEN AUF METALLOXIDBASIS
PROCESSUS DE FRITTAGE DE FORMULATIONS À BASE D'OXYDES DE MÉTAUX

(30) Priority: 12.04.2011 IT RM20110184
(43) Date of publication of application: 19.02.2014
(73) Proprietor: Dyepower, 00185 Roma (IT)
(72) Inventor: DI CARLO, Aldo, I-00185 Roma (IT); MINCUZZI, Girolamo, I-00185 Roma (IT); BROWN, Thomas, Meredith, I-00185 Roma (IT); REALE, Andrea, I-00185 Roma (IT)
(74) Representative: Santi, Filippo
(86) International application number: PCT/IT2012/000104
(87) International publication number: WO 2012/140684

(56) References cited:
- WO-A1-2010/064213
- US-A1- 2007 120 178
- GIROLAMO MINCUZZI ET AL: "Efficient sintering of nanocrystalline titanium dioxide films for dye solar cells via raster scanning laser", APPLIED PHYSICS LETTERS, vol. 95, no. 10, 1 January 2009 (2009-01-01), page 103312, XP055008602, ISSN: 0003-6951, DOI: 10.1063/1.3222915 cited in the application

## Description

The present invention relates to a process of sintering of formulations based on metal oxides, as well as a process for the production of photoelectrochemical cells comprising said process of sintering of formulations based on metal oxides.

The invention relates to the realization of sintered active layers of formulations based on metal oxides such as SnO₂, ZnO, Nb₂O₅, CeO₂, SrTiO₃, TiO₂ and more particularly, according to a preferred but not limiting embodiment of the present invention, to an electrochemical cell and its manufacturing process.

In particular, the present invention relates to the sintering of the layer of metal oxide of the cell, by using laser radiation with a wavelength in the visible and infrared region of the electromagnetic spectrum, assisted by specific pigment molecules that absorb said laser radiation converting it to heat. These pigments are to be included in the formulation of the paste of metal oxide prior to the procedure of deposition and sintering necessary for the formation of the layer of metal oxide.

Even more particularly, the invention is proposed as an application in the manufacture of photoelectrochemical cells also called, with English terminology, Dye Sensitized Solar Cells (DSSC), or more simply DSC (DSC).

DSSC are photovoltaic cells having a multi-layer structure deposited on a substrate or, more frequently, sandwiched between two conductive substrates. Typically, said substrates are made of transparent material (preferably glass, but also plastic such as PET or PEN) and are coated, on the side facing the interior of the structure, with an electrically conductive material which is also transparent (more generally a transparent conductive oxide, preferably a tin oxide doped with fluorine or an alloy of tin oxide and indium oxide, respectively said FTO and ITO). An alternative consists in the use for only one of the two electrodes, of a metal foil (eg titanium, steel, aluminum suitably treated) as the substrate.

Between the two substrates one or more photoelectrochemical cells are arranged, electrically connected to each other in series and/or in parallel. Each cell consists of a photoelectrode (the anode), placed on the conductive coating of one of the two substrates, a counter electrode (the cathode), placed on the conductive coating of the other substrate, and an electrolyte interposed between said photoelectrode and said counterelectrode. In particular, the photoelectrode is usually made of a porous semiconductor material with wide band gap, such as titanium dioxide TiO₂ or zinc oxide, which supports the active material, consisting of a pigment capable of transferring electrons in the semiconductor as a consequence of the absorption of a photon. The counter electrode is generally constituted by a thin layer of platinum, while the electrolytic solution generally contains a redox couple I⁻/I₃⁻.

Photoelectrochemical cells of this type are disclosed for example in U.S. Patent No. 4,927,721 while the materials used in this type of cells are disclosed for example in U.S. Patent No.5,350,644.

The layer of porous semiconductor material can be deposited in the form of liquid or colloidal suspension through several techniques that include, but are not limited to, screen printing, spray coating, slot-dye coating, gravure coating, flexographic printing, blade coating.

A typical suspension or colloidal paste of nanocrystalline TiO₂ consists of water and/or organic solvents (eg ethanol) and/or substances with the function of carrier such as terpineol, nanoparticles (5 to 500nm in diameter) of metal oxide, typically TiO₂, a binder viscosity modifier, such as polyethylene glycol (PEG), ethyl cellulose or polyethylene oxide and/or other substances having the function of plasticizers. The formulations for the preparation of this type of colloidal pastes are disclosed in WO9116719, WO2010/064213 and WO2007/015250 as well as in "Fabrication of ScreenPrinting Pastes From TiO2 Powders for Dye-Sensitised Solar Cells", S. Ito, et al., Progress in Photovoltaics: Research and Applications, vol. 15, 2007, p. 603-612.

As it is well known, according to the present state of the art sintering of the active layer of metal oxide is obtained by heating the whole substrate on which the above said paste of metal oxide was previously filed. The heating process is usually performed using ovens or hot plates. This process has the dual purpose of ensuring a good electromechanical bond between the particles while maintaining the porosity of the material and its surface area large enough. As disclosed in patent US5525440, the sintering takes place at relatively high temperatures, which for example are usually around 450°C - 550°C for the TiO₂.

In general, in the following description, by the term optimum sintering temperature of the metal oxides is meant the temperature at which it is necessary to bring a thin layer of a paste of said metal oxides so that, used for the manufacture of such photoelectrochemical cells, they allow to optimize the performance of the cells. For the titanium dioxide (TiO₂) in particular, and for applications of the same in photoelectrochemical cells with photovoltaic properties (which constitute a particularly preferred embodiment of the present invention and to which specific reference will be made in the following description), reference is made in particular to optimize the efficiency of converting solar energy into electricity. A vast literature shows that this temperature varies between 450°C and 550°C depending on the particular formulation of the paste of metal oxide and the thickness of the active layer produced from it. [a) L. Vesce, R. Riccitelli, "Processing and characterization of a TiO2 paste based on small particle size powders for dye-sensitized solar cell semitransparent photo-electrodes" Prog. Photovolt: Res App. 2011, DOI: 10.1002/pip.1166; b) L. Vesce, R. Riccitelli, G. Soscia, T.M. Brown, A. Di Carlo, A. Royal, "Optimization of Nanostructured titania photoanodes for dye-sensitized solar cells: Study and Experimentation of TiCl4 treatment" Journal of Non-Crystalline Solids 2010, 356: 1958-1961; c) M.K. Nazeeruddin, P. Pchy, T. Renouard, S.M. Zakeeruddin, R. Humphry-Baker, P.Comte, P. Liska, L. Cevey, E. Costa, V. Shklover, L. Sloppily, G.B. Deacon, C.A. Bignozzi, and M. Graetzel, JACS, 123, 1613, 2001; d) S. Ito, P. Chen, P. Comte, M.K. Nazeeruddin, P. Liska, P. Péchy, and M. Graetzel, Prog. Photovolt: Res Appl., 15, 603-612, 2007).

In the literature alternative processs of sintering have also been proposed, which make use of electromagnetic radiation at various frequencies, be it emitted by laser or by other devices. Compared to heating in the oven, these processes have the advantage of producing in the film a localized and selective heating, with an automated, rapid and accurate control of the area to be sintered.

This allows to select, with a high resolution, which parts are to be sintered (while the oven heats the whole substrate) with consequent obvious advantages in the construction of DSC modules, such as those with the configuration called W (where there is an alternation of TiO₂ areas with other catalyst areas).

In addition, the sintering of the film in object by irradiation with electromagnetic radiation allows the integration of photoelectrochemical cells DSSC with other materials or devices which can not be processed at high sintering temperatures.

In particular, in "Preparation of Nanocrystalline TiO2 Electrode for Dye-Sensitised Solar Cells by 28GHz Microwave Irradiation", S. Uchida et al., Solar Energy Materials & Solar Cells 81 (2004), pages 135-139, it is disclosed a process for the rapid sintering of nanocrystalline TiO₂ on a glass electrode (made conductive by a layer of transparent oxide) for the construction of DSSC, through the use of 28GHz microwave radiation. Patent US2007120178 discloses a process of sintering which provides for the use of laser radiation with a wavelength of 360nm, hence on the ultraviolet (UV) part of the spectrum. In "Laser-sintered mesoporous TiO2 electrodes for dye-sensitized solar cells", Kim et al., Appl. Phys. A 83, 73-76 (2006) and "Efficient sintering of nanocrystalline titanium dioxide films for DSC via raster scanning lasers", Mincuzzi et al. Appl Phys. Lett 95, 103312 (2009), it is also disclosed how to sinter a layer of TiO₂ using a pulsed UV laser (with a wavelength of 355 nm).

U.S. Patent No. US2007120178 discloses the localized heating of cells of metal oxides by means of irradiation with the use of both microwave radiation and generic laser radiation.

It shall be noted that the sintering process by means of laser radiation is obtained by heating locally the nanocrystalline layer of TiO₂ which is irradiated. The heating and, hence, uniform sintering of a wide area is obtained by scanning with the laser beam the whole selected surface. The complete sintering by means of laser scanning of layers of TiO₂ was used in the manufacture of ceramics of TiO₂ and for the production of functional objects based on TiO₂ [Y. Wu, J. Du, K.L. Choy, and L.L. Hench, Materials Science and Engineering A 2007, 454, p148; P.K. Venuvinod and W. But, in Rapid Prototyping: Laser-based and Other Technologies, Kluwer Academic, Boston USA, 2004]. In general, and for good reason, it can be argued that the use of laser scanning has become a tool more and more used in industry. In particular this is true for performing the so-called rapid prototyping, generic print jobs, patterning of electro-active polymers, manufacturing of electronic devices (P. Cain and H. Sirringhaus WO02095805, WO2005/039814 and patents cited in therein) and special workings of traditional and thin film semi conductor solar cells. In fact, these systems allow the execution of highly automated production processes with high precision and selectivity resulting also scalable in space and cost effective.

To date, however, the laser systems used for the sintering of the layer of TiO₂ in DSSC cells are only those with emission in the near UV (<400nm), since only at these wavelengths semiconductor oxides with broadband as TiO₂ show a significant optical absorption, as the photon energy appears to be greater than the band gap.

The lasers that emit in the near UV region, however, have the drawback to have an efficiency that is not particularly high, especially if compared with that of the lasers in the visible or infrared. This of course has a negative impact on the production costs of the cell, both in terms of energy and financial.

Furthermore, the UV radiation is absorbed also from the substrate and the transparent conductive electrodes underlying the layer of TiO₂. The UV sintering process is therefore a process with limited range, because the user must find the right parameters for which the laser is absorbed by the layer of metal oxide but not from the electrode or from the substrate, the degradation of which would seriously undermine the efficiency of the solar cell (in particular for thin layers of TiO₂). This problem is even more important when one wants to carry out the process not on the glass but on flexible plastic substrates.

A further limitation of the known solutions, also, consists in the fact that the UV laser does not allow the sintering of the layer of TiO₂ by irradiation through the substrate of glass or plastic materials since the latter are opaque to UV radiation.

In the light of the above, it appears evident the need of being able to have a process of sintering of the nanocrystalline layer of semiconductor oxide such as TiO₂ with high efficiency, which allows to optimize the financial and energy costs of the production of solar cells.

In addition, such a procedure should make it possible to obtain the sintering of the layer of TiO₂ without the substrate and the transparent conductive electrodes underlying the layer of TiOz being adversely affected as a result of the chosen sintering treatment.

In this context it is included the solution according to the present invention, which aims to provide a process of sintering of the layer of the porous metal oxide of the photoelectrochemical cell through the use of laser systems which emit in the visible and infrared region of the electromagnetic spectrum.

These and other results are obtained, according to the present invention, by inserting particular and specific pigment molecules in the formulation of the paste of metal oxide prior to the procedure of deposition and sintering. These pigments should be characterized by a high absorption of laser radiation in the visible and infrared regions of the electromagnetic spectrum, depending on which laser is chosen for sintering. Following the deposition of this active layer, it is irradiated with a scanning laser system. As already said, the pigment molecules inserted in the paste of TiO₂ are such to absorb the laser beam and, by acting as mediators, transferring heat to nanoparticles of TiO₂ finally sintering the layer of material.

The innovative aspect of the present invention lies in allowing the localized sintering of the material through the use of laser systems in the visible and IR, which otherwise could not be used effectively, since the TiO₂ absorbs significantly only for wavelengths in the region of the near UV.

Furthermore, the lasers that emit in the visible and near infrared (called Vis-IR laser) constitute a simpler, more mature and efficient technology, capable of capturing, thanks to a wide variety of applications, a large segment of the market. All this means that such laser systems require a lower financial commitment in terms of both capital and use.

Again, the opening to the use of Vis-IR laser has the enormous advantage of the possibility of obtaining a sintering also effective for plastic substrates and flexible cells, making it also possible the sintering through the substrate, with a consequent obvious advantages in terms of process.

The purpose of the present invention is therefore to provide a process of sintering that allows to overcome the limits of the solutions of the prior art and to obtain the previously described technical results.

Further object of the invention is that said process can be manufactured with substantially limited costs.

Not least, with the present invention it is provided a process which is substantially simple, safe and reliable.

It is therefore a first object of the present invention a process of sintering of metal oxide films, from formulations based on particles of metal oxides, characterized in that it comprises the following steps, in succession:
a) adding to the formulation particles or molecules of a compound absorbing the electromagnetic radiation in the regions of visible and/or infrared spectrum that, in consequence of the absorption of the radiation, generates heat;
b) mixing until a homogeneous dispersion of the absorbing compound in the formulation is obtained;
c) deposition of the formulation in the form of a film on a substrate;
d) irradiation of said film with an electromagnetic radiation in the visible and/or infrared regions of the spectrum, to obtain the desired sintering of said particles of metal oxides through the heating produced by said absorbing compound.

In particular, according to the invention, said electromagnetic radiation has a wavelength greater than 400nm and a power at least equal to 1W/cm².

Preferably, according to the invention, said formulations based on particles of metal oxides are colloidal dispersions of these metal oxides.

In addition, according to the present invention, said step of irradiation is made with a scanning Vis/IR laser system, preferably with an electromagnetic radiation with a wavelength entirely or predominantly between 500 and 1200nm.

In particular, always according to the present invention, the solid content of said molecules or particles of absorbing compound in the formulation based on metal oxides is between 0.1% and 60% by weight, preferably between 1% and 20% by weight, and said molecules or particles have extinction coefficients greater than 1 l/g·cm, preferably greater than 10 l/g·cm, at the wavelengths of the radiation used.

Preferably, according to the invention, said particles of absorbing compound have decomposition temperatures lower or equal than the optimum sintering temperature of said metal oxides.

It is further a second specific object of the present invention a process for the production of photoelectrochemical cells, comprising a step of realization of an electrode based on metal oxides and a phase of construction of a counter electrode wherein said step of realization of the electrode of metal oxides is realized according to the previously said process of sintering of metal oxide films, starting from formulations based on particles of metal oxides.

According to the invention, said process for the production of photoelectrochemical cells can further provide that the realization of the counter electrode is obtained according to the following sub-steps, in succession:
- addition to a formulation of precursors of the material of the counter electrode of molecules or particles of a compound absorbing the electromagnetic radiation in the visible and infrared regions of the spectrum which, as a result of absorption of the radiation, generates heat;
- mixing until a homogeneous dispersion of the absorbing compound in the formulation is obtained;
- deposition of the formulation in the form of films on a substrate;
- irradiation of said film with an electromagnetic radiation in the visible and/or infrared regions of the spectrum, to obtain the cooking of said film and the processing of such precursors of the material of the counter electrode through the heating produced by said absorbing compound.

Preferably, according to the invention, the molecules or particles of absorbing compound added to the formulation of precursors of the material of the counter electrode absorb at the same wavelengths of the molecules or particles of absorbing compound added to the formulation based on particles of metal oxides used for the realization of the metal oxide electrode.

More preferably, according to the present invention, said step of irradiation of the formulation based on metal oxides used for the realization of the metal oxide electrode and said step of irradiation of the formulation of precursors used for the realization of the counter electrode take place simultaneously and/or may be obtained with the same source of radiation.

It is evident the efficiency of the process of the present invention, which allows the use of industrial laser scanning systems (the vast majority in the IR) already well developed and automated for other industries. In addition, the industrial laser scanning systems are more energy efficient, with the consequence of reducing the cost of manufacture compared to the UV laser.

The fact that the sintering is obtained with IR or visible laser systems allows potentially effective sintering of films also on flexible plastic substrates, thus allowing the manufacture of efficient DSSC electrochemical cells on plastic.

Finally, the laser process has the advantage of being local, rapid, selective and scalable both on large surfaces and with different shapes.

The invention will be disclosed herein below for illustrative but not limitative purposes, with particular reference to some illustrative examples.

The embodiments of the present invention relate to processes by which films with high surface area of nanocrystalline semiconductor oxide, including TiO₂, can be sintered using visible and infrared laser. An objective of the present invention is to provide a new technique for the sintering of nanocrystalline semiconductor oxides, preferably after being deposited on a substrate from a suspension, a paste or solution which include pigments that absorb strongly at the wavelength of the laser. The invention also provides a process for the preparation of a formulation of a paste of TiO₂ by mixing in the composition of the paste a pigment that absorbs laser radiation in the visible or infrared region. Further embodiments of the present invention relate to processes through which solutions or pastes of the precursors of the counter electrode (such as those based on Pt) may be cooked using laser systems in the visible or infrared in a similar way, which is evident to a person skilled in the art.

The layers of metal oxide (for example TiO₂) for DSC are deposited on the conductive layers (usually glass or flexible sheets covered with a transparent conductive oxide). Typically, the layer of TiO₂ is deposited in the form of a paste by means of molding techniques such as screen printing, slot dye coating, spray coating. In one embodiment of the present invention, pigment molecules are added to the formulation of the paste or suspension of metal oxide nanoparticles and mixed and dispersed herewithin, before the paste or suspension is deposited to form the layer. These pigments are chosen from those which strongly absorb in the visible and infrared region of the electromagnetic spectrum so that they have a strong absorption at the wavelength of the laser that is used to obtain the heating and sintering of said layer.

In one embodiment of this invention, in order to heat through infrared laser systems (with wavelengths of 830nm or 1064nm for example) it is selected, as an absorbing pigment dispersed in the paste of TiO₂, a pigment that absorbs strongly between 800nm and 1200nm. The solid content of the pigment in the formulation of the paste will depend among other things by the extinction coefficient of the pigments at the laser wavelength, but will preferably be between 0.1% and 60%, more preferably between 1% and 20%. To the formulation of the paste of metal oxide in suspension pigments are added with extinction coefficients greater than 1 l/g·cm and preferably greater than 10 l/g·cm at the wavelengths of the laser systems. For laser systems in the visible region (eg 532 nm), which may be preferable if both the substrate (eg glass or transparent plastic materials) and the transparent conductive oxides are transparent to the visible region of the electromagnetic spectrum, other pigments are selected that strongly absorb at those wavelengths.

For the sintering process laser systems can be used with power greater than 0.1 W, preferably greater than 1W. The spot size can vary between tens of µm² and 100 mm², preferably is greater than 0.1 mm². The laser spot is scanned alternately on the sample by mounting the sample to be sintered on planar translation axes, called xy axes, or preferably, the laser beam will be scanned using rotating mirrors (known as galvo-mirrors) to increase the speed of manufacture. A further degree of freedom is the z-axis by which it is possible to adjust the distance (called defocusing distance) between the film of TiO₂ and the focal point of the laser beam and to vary the size of the spot. By controlling the scanning in the xy plane of the beam on the layer of metal oxide it is possible to scan large areas and therefore large surfaces of the layer of metal oxide can be sintered.

The molecules of pigment dispersed in the suspension of TiO₂ absorb the laser radiation and transfer the energy to the surrounding matrix of TiO₂ (TiO₂ crystals absorb significantly only in the UV region of the electromagnetic spectrum so that the heat is transferred from the pigment to the absorbent TiO₂) leading to sintering of the layer of metal oxide as required for the manufacture of efficient solar cells. The pigment molecules identified for the present invention preferably have (but are not limited to) discoloration and decomposition temperatures (for the very short time in which they are optically and thermally excited by the scanning laser beam) that are not much lower than the optimal local sintering temperatures of the layer of TiO₂, greater than 150°C (preferably greater than 350°C). Preferably, but not limited to, the pigments will decompose at such temperatures of sintering. The process is therefore self-limiting due to the fact that when the absorption of laser radiation by the absorbing pigment becomes too high, the molecules of pigment discolor and/or decompose and the laser beam will no more transfer its energy to the material. The decomposition of the molecules of the pigment is a further advantage, since the layer of TiO₂ needs to be porous to increase its active and sensitive to visible light surface area, as well as its optical density.

Subsequent to the sintering of the layer of TiO₂, the making of the DSC can be carried out as disclosed in the literature (see for example U.S. Patents No. 5525440 and 5350644 or S. Ito et al. Prog. Photovolt: Res Appl. 2006; 14:589-601).

The manufacturing process of the present invention is particularly suitable for, but not limited to, the production and sintering of nanocrystalline mesoporous films of layers of metal oxide such as those used in the DSC. Other applications for devices based on laser sintered TiO₂ include photocatalytic, electrochromic, gas detection, photocatalytic water splitting, hydrogen storage and hybrid photovoltaic devices. The same procedure can be applied to other nanocrystalline oxides with a large band gap.

In one embodiment of the present invention, pigment molecules, which will absorb the laser radiation in the subsequent phases, are added to the formulation of paste or suspension based on nanoparticles of metal oxide and mixed and dispersed therein, preferably, but not necessarily, immediately before, or immediately after, or simultaneously with the mixing of organic binders or plasticizers. For example, ethyl cellulose can be dissolved in ethanol as disclosed by S. Ito et al., Progress in Photovoltaics: Research and Applications; vol. 15, 2007, p. 603. The pigment suggested according to the present invention is preferably added at this stage. In another embodiment of the invention binder free pastes may be formulated [Kijitori Y, M Ikegami, T Miyasaka - Chemistry Letters, 2007, Vol 36 (2007), p.190]. In this case, since there is no organic binders, it appears that the only solid organic compounds present are the laser radiation absorbing pigments.

In its simplest form, the DSC comprises only one layer of metal oxide (eg TiO₂). A DSC with two layers, instead, comprises a layer of mesoporous TiO₂ with nanoparticles having a diameter of between 5nm and 50nm and a thickness of 1µm<d<25µm and a layer having the function of the back-light diffuser with particles of TiO₂ with diameter of a few hundred nm and a thickness of few microns [S. Ito et al. Progress in Photovoltaics: Research and Applications, vol. 15, 2007, p. 603]. For this architecture, the pigment can be added to one of the two layers only or to both. Preferably, but not limited to, the pigment is added to the main mesoporous layer. In other architectures, the DSC may include an additional layer of thin compact TiO₂ with a thickness typically <1µm, which is sometimes added between the electrode and the main layer of mesoporous TiO₂ [S. Ito, P. Liska, P. Comte, R. Charvet, P. Péchy, U. Bach, L. Schmidt-Mende, SM Zakeeruddin, A. Kay, MK Nazeeruddin, and M. Grätzel, Chem.Commun., 2005, 4351].

In one embodiment of this invention, for the sintering of the layer of metal oxide using an infrared laser (with wavelengths which for example may be equal to 830 nm or about 1060 nm) it is chosen as an absorbing pigment dispersed in the TiO₂ paste the compound IRA 980BT of Exciton, used in a quantity of solid preferably 0.5%-30% by weight. When using laser systems in the visible region of the spectrum, which can also be desirable if both the substrate (for example glass or transparent plastic materials) and the transparent conductive oxides are transparent in the visible region of the electromagnetic spectrum, one can choose other pigments which absorb at wavelengths belonging to the above said region of the spectrum. For laser systems in the green region of the spectrum (for example a doubled laser system Nd:YAG at 532nm or an argon laser between 490nm and 510nm, or a pulse dye laser at 595 nm) a pigment can be used and dispersed in the paste of TiO₂ as absorbing medium which absorbs strongly in the region of the green (for example, the pigment Epolight 7276C of Epolin Inc.). Other non-limiting examples of suitable pigments include those known on the market under the names SDA8703, Epolight 7541, SDA5725, SDA7047, SDA7591, SDA8700, SDA8817, and mixtures of these pigments.

In another embodiment of the present invention the absorbing pigment is dispersed in a specific layer (light absorbing layer) so that only that layer strongly absorbs the laser radiation. The heat will be transferred by the light absorbing layer to the other layers by conduction.

In another embodiment of this invention, inorganic micro-or nano-crystals are used in the formulation of the paste of nanocrystalline metal oxide, which have an absorption spectrum which reaches a peak in correspondence of the wavelengths of the laser, instead of organic or metallo-organic pigments.

The examples hereinafter reported have been focused on the preparation and sintering of metal oxide films for DSC. It will be apparent to a person skilled in the art that the present invention can be equally applied to other devices and applications such as for example but not limited to photocatalytic, electrochromic, gas detection, photocatalytic water splitting, hydrogen storage and hybrid photovoltaic devices. The same procedure of laser sintering can be applied to other nanocrystalline oxides with wide band gap such as (but not limited to) MgO, CdO, Fe₂O₃, SnO₂, ZnO, CdSe, CdS, WO₃, Nb₂O₅, and Ta₂O₅.

### Example 1

In order to obtain a colloidal paste of nanocrystalline TiO₂ for the manufacture of DSC solar cells a formulation was used in some points similar to that disclosed by S. Ito, P. Chen, P. Comte, MK Nazeeruddin, P. Liska, P. Pechy, M. Grätzel, Prog. Photovolt: Res Appl. 2007, 15, 603, but with some differences, in particular the introduction of absorbing pigments. One at a time, in the order: 6g of nanoparticles of TiO₂, 1 ml of water, 1 ml of acetic acid, 80ml of ethanol, ethyl cellulose (3g: 30g of a 10% solution in ethanol) and finally 30 ml of methylene chloride in solution with the absorbing pigment IRA 980BT were introduced and well mixed in a mortar.

In particular, the used nanoparticles of TiO₂ have a diameter of 13 nm (P90Degussa) with the addition of some particles with a variable diameter in the range 300 µm - 400 µm (Pi-kem) in the proportion by weight of 0,5g for each 6g of P90. These larger particles diffuse into the active layer part of the light otherwise lost.

The pigment, added in solution with methylene chloride, was IRA980BT (manufactured by Exciton) with a concentration of about 13.5 g/L in total considering all the solvents used. This pigment absorbed in the infrared, while maintaining a significant absorption even at wavelengths of about 1064nm which is the value of the wavelength of the neodymium laser sources. The neodymium laser sources are among the most economical laser sources available on the market both under pulsed regime CW than with optical powers with average emission from a few mW to a few kW. The whole was subsequently introduced into a multiple roller grinder and milled for a few hours. Using the technique of blade coating, the paste thus obtained was deposited on an area of 5mm x 5mm on a glassy (soda lime) and conductive substrate (tin oxide doped with fluorine (fluorine tin oxide-FTO) with a surface resistance of 8 Ω cm⁻²) which had been previously washed in an ultrasonic bath, first with acetone and then with ethanol. The height of the blade relative to the plane of the substrate was set at about 150 µm. The colloidal film thus obtained was dried on a hot plate at 100°C for 10 minutes, this phase being preferable but not necessary. As the next step, the laser scanning of the surface of the paste of TiO₂ was performed. It was used a Nd:YVO₄ pulsed laser system, with a repetition rate of the pulses of about 30 kHz, average optical output power of about 30W maximum, the wavelength of emission equal to 1064nm and a pair of xy axes for moving the sample controlled via a software interface. Once the average power output of the laser (about 10W) was set, the scanning sintering process has been optimized by varying the distance of the substrate from the focal plane, the scanning speed and the distance between two subsequent scanning lines. Subsequently, the substrates were immersed in a solution of ethanol and the dye capable of absorbing visible light, which makes the film of TiO₂ active, as previously mentioned, for about 12 hours. It is used a solution in ethanol 0.5 mM of a ruthenium-based organometallic dye, known by the name N719, and in particular the product marketed by Dyesol with the name B2.

In parallel the counter electrodes were manufactured, depositing a nanometric layer of Pt on glass and conductive substrates. This layer was obtained by depositing with the technique of blade coating a layer of a paste based on hexachloroplatinic acid (produced and marketed by Dyesol), a precursor of Pt and from which the above said nanometer layer of Pt is obtained, after suitable heat treatment to about 430°C for 15 minutes in the oven. The distance between the blade and the plane of the glassy and conductive substrate was about 80 microns. The two electrodes were then joined and sealed by means of a film thick about 60 µm of thermoplastic material (0.5 bar pressure used at a temperature of about 90°C for about 40 seconds) known under the name Surlyn. Through a hole with a diameter of 0.5 mm (subsequently sealed) practiced in the counter electrode the liquid electrolyte was finally injected. The liquid electrolyte used is a solution in 3-methoxypropionitrile of the redox couple I⁻/I₃⁻ and in particular the product marketed by Dyesol with the name "High Stability Electrolyte - EL-HSE" is used.

The cell was then measured under a solar simulator in a condition of illuminance equal to 1 W/m² AM 1.5.

### Example 2

In this second example, for the manufacture of DSC solar cells it is prepared a colloidal paste of nanocrystalline TiO₂ following the same guidelines and procedures listed in Example 1 except for the type and amount of absorbing pigments used. In fact, in this second example 140µl of methanol in solution with the pigment of the absorbent Epolight 7276C Epolin Inc. were added (4.7 g of colloidal paste) with a concentration of 30 g/L in total about considering all the solvents used. This pigment absorbs in the visible and in particular at wavelengths of approximately 532nm, which is the value of the wavelength of the neodymium laser sources duplicated in frequency through non-linear conversion processes [O. Quick, and DC Hanna, Principles of Lasers, Springer, USA 1998]. Even the neodymium laser sources duplicated in frequency are between the cheaper laser sources available on the market (especially if operating in the pulsed regime) with medium optical powers issuing from a few mW up to a few hundred W. The whole was subsequently introduced into a multiple roller grinder and milled for a few hours. Using the technique of blade coating, the paste thus obtained was deposited on an area of 5mm x 5mm on a glass (soda lime) and conductive substrate (tin oxide doped with fluorine (fluorine tin oxide-FTO) with surface resistance of 8 Ω cm⁻²) which had been previously washed in an ultrasonic bath, first with acetone and then with ethanol. The height of the blade relative to the plane of the substrate was fixed at about 150 µm. The colloidal film thus obtained was dried on a hot plate at 100°C for 10 minutes, this phase being preferable but not necessary. As the next step, the laser scanning of the surface of the TiO₂ paste was performed. It was used a system based on a pulsed Nd:YV04 laser, frequency doubled, with a repetition rate of the pulses of about 30 kHz, average optical power output of about 10W maximum, the wavelength of emission equal at 532nm and a pair of xy axes for moving the sample controlled via a software interface. Once the average power output of the laser was set (about 7W), the scanning sintering process was carried out by setting the scan speed at 1.2 mm·s⁻¹ and the distance between two successive scan lines at 0.5 mm. Subsequently, the substrates were immersed in a solution of ethanol and the dye capable of absorbing visible light, which makes the film of TiO₂ active as previously said, for about 12 hours. It was used a solution in ethanol 0.5 mM of a ruthenium-based organometallic dye, known by the name N719, and in particular the product marketed by Dyesol with the name B2.

In parallel, counter electrodes were manufactured by following the same process and procedures disclosed in example 1. The two electrodes were then joined and sealed also using the same materials and the same procedures disclosed in example 1. Through a hole with a diameter of 0.5 mm (subsequently sealed) drilled in the counter electrode the liquid electrolyte was finally injected. Also in this example, as in Example 1, the liquid electrolyte used is a solution in 3-methoxypropionitrile of the redox couple I⁻/I₃⁻, and in particular it is used the product marketed by Dyesol with the name "High Stability Electrolyte - EL-HSE".

The cell was then measured under a solar simulator in a condition of illuminance equal to 1 W/m² AM 1.5.

### Example 3

In a particularly preferred embodiment of the present invention, even the counter electrodes of a photoelectrochemical cell are obtained from a preparation of precursors of the material of the counter electrode inside which was added a pigment with high absorption of the radiation in the visible and infrared regions of the electromagnetic spectrum. By way of example, not limitative of the present invention, a formulation of precursors and pigment has been prepared consisting of a solution of hexachloroplatinic acid in 2-propanol (Ito et al. Prog. Photovolt: Res Appl. 2006; 14:589 - 601) to which the pigment 10 mM IRA980BT (manufactured by Exciton) was added. Also in this case, this pigment has been added in solution with methylene chloride, with a concentration of about 15g/L in total considering all the solvents used. The precursor solution was placed on the FTO substrate/conductive glass with a brush (other printing techniques can be used). As a subsequent step, laser scanning of the surface of the conductive substrate covered by that formulation of precursors and pigment was performed. Repeating what was done in Example 1 for the TiO₂, even in this case it was used a system based on a Nd:YVO₄ pulsed laser, already disclosed. Once again, once the average power output of the laser was set (about 10W), the scanning sintering process has been optimized by varying the distance of the substrate from the focal plane, the scanning speed and the distance between two subsequent scan lines. Also in this case the pigment used and introduced into the solution, absorbing the laser radiation, has allowed the development of local heat subsequently absorbed by the precursor, giving rise to the process of transformation of the latter in the final product, ie, Pt.

## Claims

1. A process of sintering of metal oxide films, from formulations based on particles of metal oxides, **characterized in that** it comprises the following steps, in succession:
a) adding to the formulation particles or molecules of a compound absorbing the electromagnetic radiation in the regions of visible and/or infrared spectrum that, in consequence of the absorption of the radiation, generates heat;
b) mixing until a homogeneous dispersion of the absorbing compound in the formulation is obtained;
c) deposition of the formulation in the form of a film on a substrate;
d) irradiation of said film with an electromagnetic radiation in the visible and/or infrared regions of the spectrum, to obtain the desired sintering of said particles of metal oxides through the heating produced by said absorbing compound.

2. A process of sintering according to claim 1, **characterized in that** said electromagnetic radiation has a wavelength greater than 400nm.

3. A process of sintering according to claim 1 or 2, **characterized in that** said electromagnetic radiation has a power output at least equal to 1W/cm².

4. A process of sintering according to any one of the preceding claims, **characterized in that** said formulations based on particles of metal oxides are colloidal dispersions of these metal oxides.

5. A process of sintering according to any one of the preceding claims, **characterized in that** said step of irradiation is made with a scanning Vis/IR laser system.

6. A process of sintering according to any one of the preceding claims, **characterized in that** said step of irradiation is obtained with an electromagnetic radiation with a wavelength entirely or predominantly between 500 and 1200nm.

7. A process of sintering according to any of the preceding claims, **characterized in that** the solid content of said molecules or particles of absorbing compound in the formulation based on metal oxides is between 0.1% and 60% by weight.

8. A process of sintering according to claim 7, **characterized in that** the solid content of said molecules or particles of absorbing compound in the formulation based on metal oxides is between 1%-20% by weight.

9. A process of sintering according to any of the preceding claims, **characterized in that** said molecules or particles of absorbing compound have extinction coefficients greater than 1 l/g·cm at the wavelengths of the radiation used.

10. A process of sintering according to any of the preceding claims, **characterized in that** said molecules or particles of absorbing compound have extinction coefficients greater than 10 l/g·cm at the wavelengths of the radiation used.

11. A process of sintering according to any of the preceding claims, **characterized in that** said molecules or particles of absorbing compound have decomposition temperatures lower or equal than the sintering temperature of said metal oxides.

12. Process for the production of photoelectrochemical cells, comprising a step of realization of an electrode based on metal oxides and a phase of construction of a counter electrode, **characterized in that** said step of realization of the electrode of metal oxides is realized according to the process of sintering of metal oxide films, starting from formulations based on particles of metal oxides according to claims 1-11.

13. Process for the production of photoelectrochemical cells according to claim 12, **characterized in that** said step of realization of the counter electrode is obtained according to the following sub-steps, in succession:
- addition to a formulation of precursors of the material of the counter electrode of molecules or particles of a compound absorbing the electromagnetic radiation in the visible and infrared regions of the spectrum which, as a result of absorption of the radiation, generates heat;
- mixing until a homogeneous dispersion of the absorbing compound in the formulation is obtained;
- deposition of the formulation in the form of films on a substrate;
- irradiation of said film with an electromagnetic radiation in the visible and/or infrared regions of the spectrum, to obtain the cooking of said film and the processing of such precursors of the material of the counter electrode through the heating produced by said absorbing compound.

14. Process for the production of photoelectrochemical cells according to claim 13, **characterized in that** said molecules or particles of absorbing compound added to the formulation of precursors of the material of the counter electrode absorb at the same wavelengths of the molecules or particles of absorbing compound added to the formulation based on particles of metal oxides used for the realization of the metal oxide electrode.

15. Process for the production of photoelectrochemical cells according to claim 14, **characterized in that** said step of irradiation of the formulation based on metal oxides used for the realization of the metal oxide electrode and said step of irradiation of the formulation of precursors used for the realization of the counter electrode take place simultaneously.

16. Process for the production of photoelectrochemical cells according to claim 14 or 15, **characterized in that** said step of irradiation of the formulation based on metal oxides used for the realization of the metal oxide electrode and said step of irradiation of the formulation of precursors used for the realization of the counter electrode are obtained with the same source of radiation.

## Patentansprüche

1. Ein Verfahren zum Sintern von Metalloxidschichten, aus Formulierungen auf Basis von Teilchen aus Metalloxiden, **dadurch gekennzeichnet, dass** es die folgenden aufeinanderfolgenden Schritte umfasst:
a) Hinzufügen von Teilchen oder Molekülen eines Stoffes, der elektromagnetische Strahlung in den Bereichen des sichtbaren und/oder infraroten Spektrums absorbiert und der in Folge der Absorption der Strahlung Wärme erzeugt, zu der Formulierung;
b) Mischen bis eine homogene Dispersion des absorbierenden Stoffes in der Formulierung erreicht ist;
c) Abscheidung der Formulierung in der Form eines Films auf einem Substrat;
d) Bestrahlen der Schicht mit elektromagnetischer Strahlung im sichtbaren und/oder infraroten Bereich des Spektrums, um das gewünschte Sintern der Teilchen aus Metalloxiden durch die von dem absorbierenden Stoff erzeugte Wärme zu erreichen.

2. Ein Verfahren zum Sintern nach Anspruch 1, **dadurch gekennzeichnet, dass** die elektromagnetische Strahlung eine Wellenlänge hat, die größer als 400 nm ist.

3. Ein Verfahren zum Sintern nach Anspruch 1 oder 2, **dadurch gekennzeichnet, dass** die elektromagnetische Strahlung eine Leistung von mindestens 1 W/cm² aufweist.

4. Ein Verfahren zum Sintern nach einem der vorhergehenden Ansprüche, **dadurch gekennzeichnet, dass** die Formulierung auf Basis von Teilchen aus Metalloxiden eine kolloidale Dispersion dieser Metalloxide ist.

5. Ein Verfahren zum Sintern nach einem der vorhergehenden Ansprüche, **dadurch gekennzeichnet, dass** der Bestrahlungsschritt mit einem Scan-VIS/IR-Lasersystem durchgeführt wird.

6. Ein Verfahren zum Sintern nach einem der vorhergehenden Ansprüche, **dadurch gekennzeichnet, dass** der Bestrahlungsschritt mit einer elektromagnetischen Strahlung erreicht wird, die eine Wellenlänge aufweist, die vollständig oder überwiegend zwischen 500 und 1200 nm liegt.

7. Ein Verfahren zum Sintern nach einem der vorhergehenden Ansprüche, **dadurch gekennzeichnet, dass** der Feststoffanteil der Moleküle oder Partikel des absorbierenden Stoffes in der Formulierung auf Basis von Metalloxiden zwischen 0,1 und 60 Gewichtsprozent liegt.

8. Ein Verfahren zum Sintern nach Anspruch 7, **dadurch gekennzeichnet, dass** der Feststoffanteil der Moleküle oder Partikel des absorbierenden Stoffes in der Formulierung auf Basis von Metalloxiden zwischen 1-20 Gewichtsprozent liegt.

9. Ein Verfahren zum Sintern nach einem der vorhergehenden Ansprüche, **dadurch gekennzeichnet, dass** die Moleküle oder Partikel des absorbierenden Stoffes Extinktionskoeffizienten aufweisen, die größer sind als 1 l/g*cm bei der für die Bestrahlung verwendeten Wellenlänge.

10. Ein Verfahren zum Sintern nach einem der vorhergehenden Ansprüche, **dadurch gekennzeichnet, dass** die Moleküle oder Partikel des absorbierenden Stoffes Extinktionskoeffizienten aufweisen, die größer sind als 10 l/g*cm bei der für die Bestrahlung verwendeten Wellenlänge.

11. Ein Verfahren zum Sintern nach einem der vorhergehenden Ansprüche, **dadurch gekennzeichnet, dass** die Moleküle oder Partikel des absorbierenden Stoffes Zersetzungstemperaturen haben, die kleiner oder gleich der Sintertemperatur der Metalloxide sind.

12. Verfahren zur Herstellung von fotoelektrochemischen Zellen, umfassend einen Schritt einer Realisierung einer Elektrode auf Basis von Metalloxiden und einer Phase des Aufbaus einer Gegenelektrode, **dadurch gekennzeichnet, dass** der Schritt der Realisierung der Elektrode aus Metalloxiden gemäß dem Verfahren zum Sintern von Metalloxidschichten, ausgehend von Formulierungen auf Basis von Teilchen aus Metalloxiden, gemäß den Ansprüchen 1 bis 11 durchgeführt wird.

13. Verfahren zur Herstellung von fotoelektrochemischen Zellen nach Anspruch 12, **dadurch gekennzeichnet, dass** der Schritt zur Realisierung der Gegenelektrode gemäß der folgenden aufeinanderfolgenden Unterschritte erreicht wird:
- Hinzufügen von Molekülen oder Partikeln eines Stoffes, der die elektromagnetische Strahlung im sichtbaren und im infraroten Bereich des Spektrums absorbiert, der in Folge der Absorption der Strahlung Wärme erzeugt, zu einer Formulierung von Ausgangsstoffen des Materials der Gegenelektrode;
- Mischen, bis eine homogene Dispersion des absorbierenden Stoffes in der Formulierung erhalten wird;
- Abscheidung der Formulierung in Form von Schichten auf einem Substrat;
- Bestrahlung der Schicht mit elektromagnetischer Strahlung im sichtbaren und/oder infraroten Bereich des Spektrums, um das Kochen dieser Schicht und die Verarbeitung der Ausgangsstoffe des Materials der Gegenelektrode durch die Erwärmung, die von dem absorbierenden Stoff erzeugt wird, zu erzeugen.

14. Verfahren zur Herstellung von fotoelektrochemischen Zellen nach Anspruch 13, **dadurch gekennzeichnet, dass** die Moleküle oder Partikel des absorbierenden Stoffes, die der Formulierung der Ausgangsstoffe des Materials der Gegenelektrode hinzugefügt werden, bei der gleichen Wellenlänge absorbieren wie die Moleküle oder Partikel des absorbierenden Stoffes, die der Formulierung auf Basis von Teilchen aus Metalloxiden zur Realisierung der Metalloxidelektrode hinzugefügt werden.

15. Verfahren für die Herstellung von fotoelektrochemischen Zellen nach Anspruch 14, **dadurch gekennzeichnet, dass** der Schritt der Bestrahlung der Formulierung auf Basis von Metalloxiden, die für die Realisierung der Metalloxidelektrode verwendet werden, und der Schritt der Bestrahlung der Formulierung der Ausgangsstoffe, die für die Realisierung der Gegenelektrode verwendet werden, gleichzeitig stattfinden.

16. Verfahren zur Herstellung von fotoelektrochemischen Zellen nach Anspruch 14 oder 15, **dadurch gekennzeichnet, dass** der Schritt der Bestrahlung der Formulierung auf Basis von Metalloxiden, die für die Realisierung der Metalloxidelektrode verwendet werden, und der Schritt der Bestrahlung der Formulierung von Ausgangsstoffen, die für die Realisierung der Gegenelektrode verwendet werden, mittels der gleichen Strahlungsquelle durchgeführt werden.

## Revendications

1. Procédé de frittage de films d'oxydes de métal, à partir de formulations à base de particules d'oxydes de métal, **caractérisé en ce qu'**il comprend les étapes suivantes, les unes à la suite des autres :
a) Ajout, à la formulation, de particules ou de molécules d'un composé absorbant le rayonnement électromagnétique dans les régions du spectre visible et/ou infrarouge qui, en conséquence de l'absorption du rayonnement, génère de la chaleur ;
b) mélange jusqu'à ce qu'une dispersion homogène du composé absorbant dans la formulation soit obtenue ;
c) dépôt de la formulation sous la forme d'un film sur un substrat ;
d) irradiation dudit film avec un rayonnement électromagnétique dans les régions visible et/ou infrarouge du spectre, pour obtenir le frittage souhaité desdites particules d'oxydes de métal par le biais du chauffage produit par ledit procédé absorbant.

2. Procédé de frittage selon la revendication 1, **caractérisé en ce que** ledit rayonnement électromagnétique a une longueur d'onde supérieure à 400 nm.

3. Procédé de frittage selon la revendication 1 ou 2, **caractérisé en ce que** ledit rayonnement électromagnétique a une puissance en sortie au moins égale à 1 W/cm².

4. Procédé de frittage selon l'une quelconque des revendications précédentes, **caractérisé en ce que** lesdites formulations à base de particules d'oxydes de métal sont des dispersions colloïdales de ces oxydes de métal.

5. Procédé de frittage selon l'une quelconque des revendications précédentes, **caractérisé en ce que** ladite étape d'irradiation est effectuée avec un système de balayage laser visible/infrarouge.

6. Procédé de frittage selon l'une quelconque des revendications précédentes, **caractérisé en ce que** ladite étape d'irradiation est obtenue avec un rayonnement électromagnétique ayant une longueur d'onde entièrement ou majoritairement entre 500 et 1200 nm.

7. Procédé de frittage selon l'une quelconque des revendications précédentes, **caractérisé en ce que** la teneur en matières solides desdites molécules ou particules de composé absorbant dans la formulation à base d'oxydes de métal se situe entre 0,1 % et 60 % en poids.

8. Procédé de frittage selon la revendication 7, **caractérisé en ce que** la teneur en matières solides desdites molécules ou particules de composé absorbant dans la formulation à base d'oxydes de métal se situe entre 1 %-20 % en poids.

9. Procédé de frittage selon l'une quelconque des revendications précédentes, **caractérisé en ce que** lesdites molécules ou particules de composé absorbant ont des coefficients d'extinction supérieurs à 1 l/g·cm aux longueurs d'onde du rayonnement utilisé.

10. Procédé de frittage selon l'une quelconque des revendications précédentes, **caractérisé en ce que** lesdites molécules ou particules de composé absorbant ont des coefficients d'extinction supérieurs à 10 l/g·cm aux longueurs d'onde du rayonnement utilisé.

11. Procédé de frittage selon l'une quelconque des revendications précédentes, **caractérisé en ce que** lesdites molécules ou particules de composé absorbant ont des températures de décomposition inférieures ou égales à la température de frittage desdits oxydes de métal.

12. Procédé pour la production de cellules photoélectrochimiques, comprenant une étape de réalisation d'une électrode sur la base d'oxydes de métal et une phase de construction d'une contre-électrode, **caractérisé en ce que** ladite étape de réalisation de l'électrode d'oxydes de métal est réalisée selon le procédé de frittage de films d'oxydes de métal, en partant de formulations à base de particules d'oxydes de métal, selon les revendications 1-11.

13. Procédé pour la production de cellules photoélectrochimiques selon la revendication 12, **caractérisé en ce que** ladite étape de réalisation de la contre-électrode est obtenue selon les sous-étapes suivantes, les unes à la suite des autres :
- addition à une formulation de précurseurs du matériau de la contre-électrode de molécules ou de particules d'un composé absorbant le rayonnement électromagnétique dans les régions visible et infrarouge du spectre qui, suite à l'absorption du rayonnement, génère de la chaleur ;
- mélange jusqu'à ce qu'une dispersion homogène du composé absorbant dans la formulation soit obtenue ;
- dépôt de la formulation sous la forme de films sur un substrat ;
- irradiation dudit film avec un rayonnement électromagnétique dans les régions visible et/ou infrarouge du spectre, pour obtenir la cuisson dudit film et la transformation de tels précurseurs du matériau de la contre-électrode par le biais du chauffage produit par ledit composé absorbant.

14. Procédé pour la production de cellules photoélectrochimiques selon la revendication 13, **caractérisé en ce que** lesdites molécules ou particules de composé absorbant ajoutées à la formulation de précurseurs du matériau de la contre-électrode absorbent aux mêmes longueurs d'onde des molécules ou particules de composé absorbant ajoutées à la formulation à base de particules d'oxydes de métal utilisée pour la réalisation de l'électrode d'oxydes de métal.

15. Procédé pour la production de cellules photoélectrochimiques selon la revendication 14, **caractérisé en ce que** ladite étape d'irradiation de la formulation à base d'oxydes de métal utilisés pour la réalisation de l'électrode d'oxydes de métal et ladite étape d'irradiation de la formulation de précurseurs utilisée pour la réalisation de la contre-électrode ont lieu simultanément.

16. Procédé pour la production de cellules photoélectrochimiques selon la revendication 14 ou 15, **caractérisé en ce que** ladite étape d'irradiation de la formulation à base d'oxydes de métal utilisés pour la réalisation de l'électrode d'oxydes de métal et ladite étape d'irradiation de la formulation de précurseurs utilisée pour la réalisation de la contre-électrode sont obtenues avec la même source de rayonnement.
